# EUROPEAN PATENT APPLICATION

(11) **EP 4 832 692 A1**
(43) Date of publication of application: **28.10.2026**
(21) Application number: 25191798.5
(22) Date of filing: 25.07.2025
(51) Int. Cl.: H10F 19/80, H10F 19/90

(54) **PHOTOVOLTAIC MODULE**

(30) Priority: 27.04.2025 CN 202510542370
(71) Applicant: Jinko Solar (Shangrao) Co., Ltd., Shangrao, Jiangxi 334100 (CN); Jinko Solar (Haining) Co., Ltd., Haining City, Zhejiang 314415 (CN)
(72) Inventor: WANG, Luchuang, Shangrao, 334100 (CN); BAI, Meiyan, Shangrao, 334100 (CN); QIN, Niannian, Shangrao, 344100 (CN); HAN, Xiangchao, Shangrao, 334100 (CN); XU, Tao, Shangrao, 334100 (CN)
(74) Representative: Rösler Rasch van der Heide & Partner

(57) **Abstract**

Provided is photovoltaic module, including: solar cell strings, first connection structure, second connection structure, adhesive film and cover plate. Each cell string includes cells including first cells having chamfers and second cells free of chamfers, first and second cells are N segmented cells formed by cutting monolithic cell, N is greater than or equal to 3, and cell string includes oppositely disposed head end and tail end; two opposite sides of first connection structure electrically connect equal number of cell strings, first connection structure is electrically connected to cells at head ends of cell strings, and cells at tail ends of cell strings located on same side of first connection structure are all first cells or second cells; adhesive film is located on surfaces of cell strings; and cover plate is located on surface of adhesive film away from cell strings. Performance and attractiveness of photovoltaic module are improved.

## Description

### TECHNICAL FIELD

Embodiments of the present disclosure relate to the field of photovoltaics and, in particular, to a photovoltaic module.

### BACKGROUND

Currently, global energy consumption is rapidly increased, traditional fossil energy is increasingly depleted, and an energy problem and an environmental problem gradually become two globally-concerned major problems. Due to the pressure of environmental pollution and sustainable development, researchers enroll the solar photovoltaic industry into focuses of development and utilization of renewable energy.

A photovoltaic module is an important device for converting solar energy into electric energy. However, the current photovoltaic module has large power loss, so that the performance of the photovoltaic module is poor.

### SUMMARY

Embodiments of the present disclosure provide a photovoltaic module, which at least facilitates an improvement of the performance of the photovoltaic module and improves the attractiveness of the photovoltaic module.

According to some embodiments of the present disclosure, there is provided a photovoltaic module, including: a plurality of solar cell strings, each solar cell string including a plurality of solar cells, the plural solar cells including first solar cells having chamfers and second solar cells free of chamfers, the first solar cells and the second solar cells being N segmented solar cells formed by cutting a monolithic solar cell, N being greater than or equal to 3, and each solar cell string including a head end and a tail end which are oppositely disposed; a first connection structure, two opposite sides of the first connection structure electrically connecting the same number of solar cell strings, the first connection structure being electrically connected with the solar cells at the head ends of the solar cell strings, and the solar cells at the tail ends of the plurality of solar cell strings located on the same side of the first connection structure being all the first solar cells or the second solar cells; second connection structures located on two opposite sides of the first connection structure and electrically connected with the solar cells at the tail ends of the solar cell strings; an adhesive film located on surfaces of the solar cell strings; and a cover plate located on a surface of the adhesive film away from the solar cell strings.

In some embodiments, the solar cells at the tail ends of the plurality of solar cell strings located on one side of the first connection structure are the first solar cells, and the solar cells at the tail ends of the plurality of solar cell strings located on the other side of the first connection structure are the second solar cells.

In some embodiments, the first solar cell includes a cut surface and a non-cut surface which are oppositely disposed, and the chamfers of the first solar cell are arranged on two sides of the non-cut surface; the non-cut surfaces of the first solar cells on the same solar cell string are oriented in the same direction.

In some embodiments, the first connection structure includes a plurality of first busbars distributed at intervals along a first direction, and the first busbars extend along the first direction; the direction of the non-cut surface of the first solar cell on one side of the first busbar is opposite to that of the non-cut surface of the first solar cell on the other side of the first busbar.

In some embodiments, at least two solar cell strings are connected to one side of the first busbar, the adjacent solar cell strings on one side of the first busbar include the same number of first solar cells and the same number of second solar cells, the adjacent first solar cells in the adjacent solar cell strings are arranged along the first direction, and the adjacent second solar cells in the adjacent solar cell strings are arranged along the first direction.

In some embodiments, each of the two opposite sides of the first busbar electrically connects two solar cell strings; the second connection structure includes: a second busbar and a third busbar spaced apart along the first direction, the second busbar extends along the first direction and electrically connects the solar cells at the tail ends of four solar cell strings, and the third busbar extends along the first direction and electrically connects the solar cells at the tail ends of two solar cell strings.

In some embodiments, the photovoltaic module further includes: a first jumper extending in a second direction, the first jumper electrically connecting the second busbars on both sides of the first busbar; and a second jumper extending in the second direction, the second jumper electrically connecting the third busbars on both sides of the first busbar.

In some embodiments, the photovoltaic module includes a first edge and a second edge which are opposite, the plurality of first busbars include a first edge busbar, a second edge busbar and an intermediate busbar, the first edge busbar is adjacent to the first edge, the second edge busbar is adjacent to the second edge, and the intermediate busbar is located between the first edge busbar and the second busbar; the first edge busbar and the second busbar electrically connect two solar cell strings, and in the two electrically connected solar cell strings, the non-cut surfaces of the first solar cells are oriented in the same direction; the intermediate busbar and the second busbar electrically connect two solar cell strings, and in the two electrically connected solar cell strings, the non-cut surfaces of the first solar cells are oriented in the same direction; the second edge busbar and the third busbar electrically connect two solar cell strings, and in the two electrically connected solar cell strings, the non-cut surfaces of the first solar cells are oriented in the same direction.

In some embodiments, the adjacent solar cells in the solar cell string are partially overlapped, a length of a partially overlapped region of the adjacent solar cells along the second direction is a first length, and the first length ranging from 0 mm to 0.4 mm.

In some embodiments, the photovoltaic module includes first solar cells and second solar cells which are formed by cutting fifty one monolithic solar cells.

The technical solution of the embodiments of the present disclosure at least has the following advantages.

In the photovoltaic module according to the embodiments of the present disclosure, the solar cells are the N segmented solar cells formed by cutting the monolithic solar cell. The larger N is, the smaller the area of the solar cell is, and N in the embodiments of the present disclosure is larger than or equal to 3, that is, the value of N is large, so that the area of the solar cell is small, and a current transmission path on the solar cell can be short, thereby enabling the current loss on the solar cell to be small, and facilitating an improvement of the performance of the photovoltaic module. In addition, the plurality of solar cells include the first solar cells with the chamfers and the second solar cells without the chamfers, and the solar cells at the tail ends of the plurality of solar cell strings on the same side of the first connection structure are all the first solar cells or the second solar cells, so that the solar cells at the tail ends of the plurality of solar cell strings on the same side of the first connection structure are arranged regularly, thus improving the attractiveness of the photovoltaic module.

### BRIEF DESCRIPTION OF DRAWINGS

One or more embodiments are illustrated by corresponding figures in the drawings, these illustrations do not constitute limitations on the embodiments, and unless stated otherwise, the figures in the drawings do not constitute a scale limitation. To better describe the technical solutions in the embodiments of the present disclosure or the related art, the following briefly describes the accompanying drawings required for the embodiments. Apparently, the accompanying drawings in the following description show merely some embodiments of the present disclosure, and a person of ordinary skill in the art may still derive other drawings from these accompanying drawings without creative efforts.
FIG. 1 is a schematic structural diagram of a photovoltaic module according to one or more embodiments of the present disclosure;
FIG. 2 is a schematic structural diagram of a solar cell string in one or more embodiments of the present disclosure;
FIG. 3 is a schematic structural diagram of a monolithic solar cell in one or more embodiments of the present disclosure;
FIG. 4 is a schematic structural diagram of solar cells cut along a dotted line in FIG. 3;
FIG. 5 is a schematic sectional structural diagram of the photovoltaic module according to one or more embodiments of the present disclosure;
FIG. 6 is a schematic structural diagram of adjacent solar cells and solder strips in the photovoltaic module according to one or more embodiments of the present disclosure;
FIG. 7 is a schematic partial enlarged diagram of a first connection structure in FIG. 1;
FIG. 8 is a schematic sectional structural diagram of a first jumper, an isolation film and the solar cell in the photovoltaic module according to one or more embodiments of the present disclosure;
FIG. 9 is a schematic circuit diagram of the photovoltaic module according to one or more embodiments of the present disclosure; and
FIG. 10 is another schematic circuit diagram of the photovoltaic module according to one or more embodiments of the present disclosure.

### DESCRIPTION OF EMBODIMENTS

In the related art, solar cells in a photovoltaic module are usually 2-segmented solar cells of a monolithic solar cell, and the area of the solar cells is large, so that a current transmission path on the solar cells is long, and thus, the current loss on the solar cells is large, and the performance of the photovoltaic module is poor.

Therefore, the performance of the photovoltaic module in the related art needs to be improved.

In a photovoltaic module according to embodiments of the present disclosure, solar cells are N segmented solar cells formed by cutting a monolithic solar cell. N is larger than or equal to 3, that is, the value of N is large, so that the area of the solar cell is small, and a current transmission path on the solar cell can be short, thereby enabling the current loss on the solar cell to be small, and facilitating an improvement of the performance of the photovoltaic module. In addition, the plurality of solar cells include first solar cells having chamfers and second solar cells free of chamfers, and the solar cells at tail ends of a plurality of solar cell strings on the same side of a first connection structure are all the first solar cells or the second solar cells, so that the solar cells at the tail ends of the plurality of solar cell strings on the same side of the first connection structure are arranged regularly, thus improving the attractiveness of the photovoltaic module.

In the description of embodiments of the present disclosure, technical terms "first", "second" and the like are intended only to distinguish different objects, which shall not be construed as indicating or implying a relative importance, or implicitly specifying the number, a particular order or primary and secondary relations of the indicated technical features. In the description of embodiments of the present disclosure, "a plurality of" means two or more, unless specifically stated otherwise.

The "embodiments" mentioned herein means that particular features, structures or characteristics described with reference to the embodiments may be included in one or more embodiments of the present disclosure. Phrases appearing at various positions of the specification neither always refer to the same embodiments, nor separate or alternative embodiments that are mutually exclusive with other embodiments. It is explicitly and implicitly understood by those skilled in the art that the embodiments described herein may be combined with other embodiments.

In the description of embodiments of the present disclosure, the term "and/or" is merely an association relationship describing associated objects, indicating that three relationships may exist. For example, A and/or B indicates that there are three cases of A, A and B together, and B. In addition, the character "/" herein generally means that associated objects before and after "/"are in an "or" relationship.

In the description of embodiments of the present disclosure, the term "a plurality of" means two or more. Similarly, "a plurality of groups" means two or more groups, and "a plurality of pieces" means two or more pieces.

In the description of embodiments of the present disclosure, the orientation or position relationship indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", etc. are based on the orientation or position relationship shown in the accompanying drawings and are only intended to facilitate the description of embodiments of the present disclosure and simplify the description, rather than indicating or implying that the device or element referred to must have a particular orientation or be constructed and operated in a particular orientation, and therefore are not to be interpreted as limitations on the embodiments of the present disclosure.

In the description of embodiments of the present disclosure, unless specifically stated and limited, the technical terms "mounting," "coupling", "connecting" and "fixing" should be understood in a broad sense, such as, a fixed connection, a detachable connection, or an integral connection; a mechanical connection or an electrical connection; a direct connection, an indirect connection through an intermediate medium, an internal connection of two elements, or an interaction of two elements. For those of ordinary skill in the art, the specific meanings of the above terms in embodiments of the present disclosure can be understood on case-by-case.

In the drawings corresponding to embodiments of the present disclosure, the thicknesses and areas of layers are exaggerated for better understanding and ease of description. When a component (e.g., layer, film, region, or base) is described as being on another component or on a surface thereof, it can be "directly" on the surface of the other component or a third component can be present between the two components. Conversely, when a component is described as being on a surface of another component or a surface of a component is described as being formed or provided with another component, there is no third component between the two components. Furthermore, when a component is described as being formed "substantially" on another component, the component is not formed on the entire surface (or front surface) of the other component, nor on a partial edge of the entire surface.

In the description of embodiments of the present disclosure, when a component "includes" another component, other components are not excluded unless otherwise stated, and the other components may be further included. Furthermore, when a layer, film, region, plate, or the like, is referred to as being "on/located on" another component, it can be "directly on" the other component (i.e., on a surface of the other component without other components therebetween) or another component is present therebetween. Furthermore, when a layer, film, region, plate, or the like, is "directly on" another component, or when a layer, film, region, plate, or the like, is on a surface of another component, no other component is located therebetween.

Embodiments of the present disclosure will be described in detail below with reference to the accompanying drawings. However, it may be appreciated by those of ordinary skill in the art that in the embodiments of the present disclosure, numerous technical details are set forth in order to enable a reader to better understand the present disclosure. However, it is possible to implement the technical solution claimed by the present disclosure without these technical details and variations and modifications based on the following embodiments.

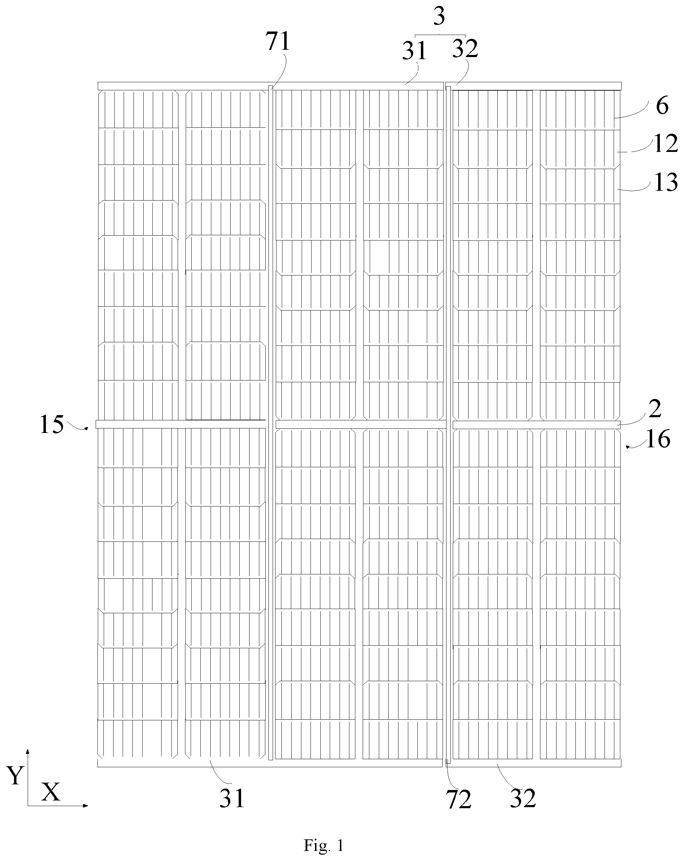

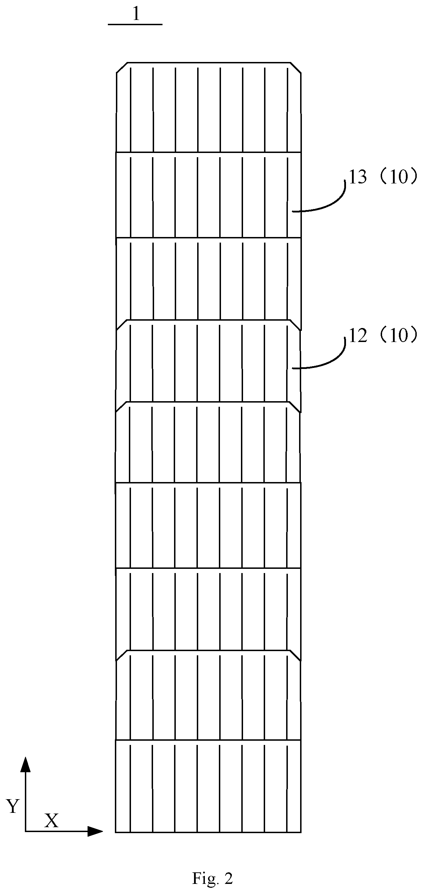

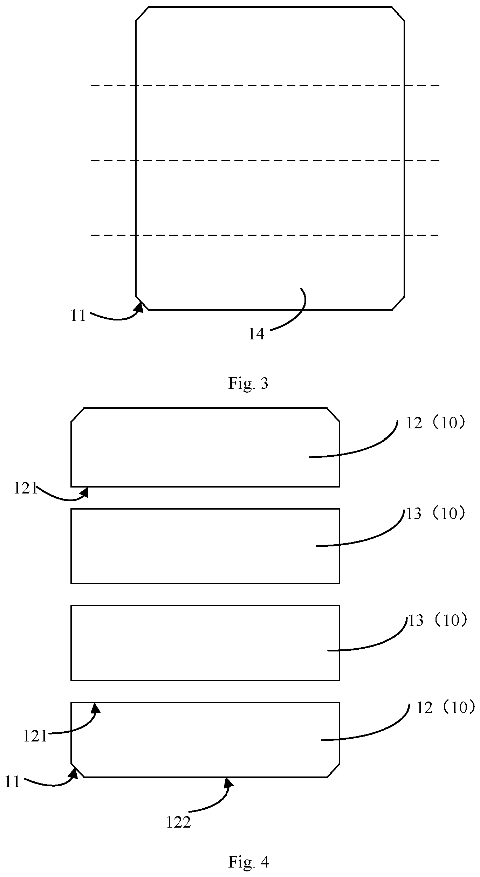

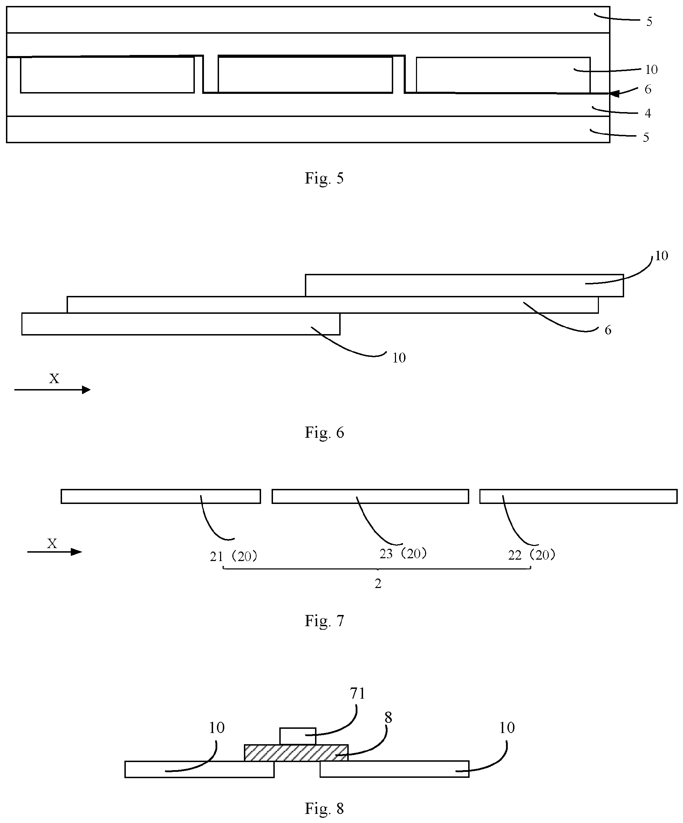

FIG. 1 is a schematic structural diagram of a photovoltaic module according to one or more embodiments of the present disclosure; FIG. 2 is a schematic structural diagram of a solar cell string in one or more embodiments of the present disclosure; FIG. 3 is a schematic structural diagram of a monolithic solar cell in one or more embodiments of the present disclosure; FIG. 4 is a schematic structural diagram of solar cells cut along a dotted line in FIG. 3; FIG. 5 is a schematic sectional structural diagram of the photovoltaic module according to one or more embodiments of the present disclosure.

With combined reference to FIG. 1 to FIG. 5, a photovoltaic module includes: a plurality of solar cell strings 1, a first connection structure 2, a second connection structure 3, an adhesive film 4 and a cover plate 5. The solar cell string 1 includes a plurality of solar cells 10, the plural solar cells 10 include first solar cells 12 having chamfers 11 and second solar cells 13 free of chamfers 11, the first solar cells 12 and the second solar cells 13 are N segmented solar cells formed by cutting a monolithic solar cell 14, N is greater than or equal to 3, and the solar cell string 1 includes a head end and a tail end which are oppositely disposed. Two opposite sides of the first connection structure 2 electrically connect the same number of solar cell strings 1, the first connection structure 2 is electrically connected with the solar cells 10 at the head ends of the solar cell strings 1, and the solar cells 10 at the tail ends of the plurality of solar cell strings 1 located on the same side of the first connection structure 2 are all the first solar cells 12 or the second solar cells 13. The second connection structures 3 are located on two opposite sides of the first connection structure 2 and electrically connected with the solar cells 10 at the tail ends of the solar cell strings 1. The adhesive film 4 is located on surfaces of the solar cell strings 1. The cover plate 5 is located on a surface of the adhesive film 4 away from the solar cell strings 1.

The solar cell 10 in the solar cell string 1 may be one of a passivated emitter rear cell (PERC), an interdigitated back contact (IBC) cell, a tunnel oxide passivated contact (TOPCon) cell, a heterojunction technology (HIT/HJT) cell, a solar thin-film cell and a tandem cell, or any combination thereof. The solar thin-film cell includes, but is not limited to, a perovskite solar thin-film cell, a copper indium selenium solar thin-film cell, a gallium arsenide solar thin-film cell, and a cadmium sulfide solar thin-film cell. The tandem cell is formed by laminating a perovskite cell and a crystalline silicon cell, a perovskite cell and a perovskite cell, as well as a perovskite cell and a thin-film cell. FIG. 1 to FIG. 5 take the TOPCon cell as the solar cell 10 as an example.

In some embodiments, the solar cell 10 may be a solar cell with a busbar or a solar cell without a busbar.

In some cases, in the case where the solar cell 10 is a solar cell having a busbar, a surface of the solar cell 10 is provided with a plurality of busbars arranged at intervals and a plurality of fingers arranged at intervals, and the busbars include busbar connecting lines and bonding pads located on the busbar connecting lines. In the process of constructing the solar cell string 1 by using the solar cells 10, a solder strip 6 is electrically connected with at least one busbar on each solar cell 10 of two adjacent solar cells 10. As a manner of the electric connection of the solder strip 6 and the busbar, the solder strip can be electrically connected with the bonding pad by welding, or the solder strip 6 can be fixed above the busbar through glue points in advance, and the solder strip 6 is electrically connected with the busbar through fusion of the glue points and deformation of the solder strip 6 in a laminating process.

In some other cases, in the case where the solar cell 10 is a solar cell without a busbar, the surface of the solar cell 10 is provided with a plurality of fingers arranged at intervals, and in the process of constructing the solar cell string 1 by using the solar cells 10, the solder strip 6 is electrically connected with the plural fingers on each solar cell 10 of two adjacent solar cells 10. The solder strip 6 can be fixed at a specific position above the solar cell 10 through glue points, and then, the electric connection between the solder strip 6 and the finger is realized through fusion of the glue points and deformation of the solder strip 6 in a laminating molding process.

In some embodiments, the photovoltaic module includes first solar cells 12 and second solar cells 13 which are formed by cutting fifty one monolithic solar cells 14. Compared with a solution of adopting 72 or 66 solar cells formed by cutting the monolithic solar cell in the related art, when the solar cells 10 formed by cutting 51 monolithic solar cells 14 are adopted for the photovoltaic module, the size of the photovoltaic module can be reduced, so that the photovoltaic module can be adapted to more application scenarios, thereby facilitating an improvement of the practicability of the photovoltaic module.

In some embodiments, the width of the photovoltaic module along a first direction X can be 1,130 mm-1,140 mm, for example, 1,130 mm, 1,132 mm, 1,134 mm, 1,136 mm, 1,138 mm, or 1,140 mm; the length of the photovoltaic module along a second direction Y can be 1,854 mm-1,906 mm, for example, 1,854 mm, 1,860 mm, 1,870 mm, 1,880 mm, 1,890 mm, 1,900 mm or 1,906 mm.

FIG. 6 is a schematic structural diagram of adjacent solar cells and solder strips in the photovoltaic module according to one or more embodiments of the present disclosure.

Referring to FIG. 2 and FIG. 6, in some embodiments, the adjacent solar cells 10 in the solar cell string 1 are partially overlapped, the length of a partially overlapped region of the adjacent solar cells 10 along the second direction Y is a first length, and the first length is 0-0.4mm, for example, 0.1mm, 0.2mm, 0.3mm, or 0.4mm. The adjacent solar cells 10 in the solar cell string 1 are partially overlapped, so that the length of the solar cell string 1 can be reduced, a reduction of the size of the photovoltaic module is facilitated, and the photovoltaic module can be adapted to more application scenarios, thereby facilitating the improvement of the practicability of the photovoltaic module. The first length within the above range can reduce the size of the photovoltaic module, and meanwhile avoid that the overlapped region is excessively large to influence sunlight absorption of the solar cell 10.

In some embodiments, a buffer member (not shown) may be arranged between the solder strip 6 and the solar cell 10, and the buffer member is arranged in the overlapped region. The buffer member can provide a buffer force for the locally rearranged solar cells 10 to reduce rigid contact between the solar cells 10 and the solder strip 6, thereby avoiding that the solder strip 6 directly presses the solar cells 10 in the laminating process to crack the solar cells 10.

The buffer member may be made of ethylene-vinyl acetate (EVA) copolymers, rubber, or the like.

Referring to FIG. 2, FIG. 4, and FIG. 6, in some embodiments, the size of the chamfer 11 of the first solar cell 12 is smaller than or equal to the first length. Thus, when the second solar cell 13 is placed on the first solar cell 12 with the chamfer 11, since the size of the chamfer 11 of the first solar cell 12 is smaller than or equal to the first length, the chamfer 11 can be prevented from being exposed, so that the appearance of the partially shielded first solar cell 12 is similar to that of the partially shielded second solar cell 13, and the appearances of the solar cells 10 in the solar cell string 1 can be similar, thereby facilitating an improvement of the attractiveness of the photovoltaic module.

In some embodiments, the adjacent solar cells 10 in the solar cell string 1 may also be arranged at intervals, and the distance between the adjacent solar cells 10 along the second direction Y may be 0-1.5 mm, for example, 0.1 mm, 0.3 mm, 0.5 mm, 0.8 mm, 1 mm, or 1.5 mm.

Referring to FIG. 2 to FIG. 4, the solar cells 10 in the solar cell string 1 are N segmented solar cells formed by cutting the monolithic solar cell 14, and N is greater than or equal to 3. For example, N may be 3, 4, 5, or the like. Each boundary of the solar cell 14 is provided with the chamfer 11 to reduce stress outside the solar cell and prevent damage to corners of the solar cell. After the monolithic solar cell 14 is cut, the first solar cell 12 with the chamfer 11 and the second solar cell 13 without the chamfer 11 are formed.

In some embodiments, the width of the solar cell 14 along the first direction X is 180mm-190mm, for example, 180mm, 182mm, 184mm, 186mm, or 188mm; the length of the solar cell 14 along the second direction Y is 210mm-220mm, for example, 210mm, 212mm, 214mm, 216mm or 218mm.

In some embodiments, the first solar cell 12 includes a cut surface 121 and a non-cut surface 122 which are oppositely disposed, and the chamfers 11 of the first solar cell 12 are arranged on two sides of the non-cut surface 122; the non-cut surfaces 122 of the first solar cells 12 on the same solar cell string 1 are oriented in the same direction. After cutting along the dotted line in FIG. 3, the second solar cell 13 has 2 oppositely disposed cut surfaces 121, while the first solar cell 12 has only one non-cut surface 122, and the chamfers 11 are located on the two opposite side of the non-cut surface 122, that is, the direction of the non-cut surface 122 affects the position of the chamfer 11. The non-cut surfaces 122 of the first solar cells 12 on the same solar cell string 1 are oriented in the same direction, so that the chamfers 11 of the first solar cells 12 on a single solar cell string 1 are regularly arranged, which is beneficial to improving the attractiveness of the photovoltaic module.

The direction of the non-cut surface 122 of the first solar cell 12 refers to a direction from the non-cut surface 122 to the non-cut surface 122 in the first solar cell 12.

In some embodiments, the solar cells 10 at the tail ends of the plurality of solar cell strings 1 located on one side of the first connection structure 2 are the first solar cells 12, and the solar cells 10 at the tail ends of the plurality of solar cell strings 1 located on the other side of the first connection structure 2 are the second solar cells 13. With this arrangement, a user can distinguish the two sides of the first connection structure 2 by judging whether the solar cell 10 at the tail end of the solar cell string 1 is the first solar cell 12 or the second solar cell 13, so that the user can conveniently confirm the relative orientation of the solar cell string 1 and the first connection structure 2.

The first connection structure 2 is configured to be electrically connected with the solar cell 10 at the head end of the solar cell string 1, and the second connection structure 3 is configured to be electrically connected with the solar cell 10 at the tail end of the solar cell string 1.

FIG. 7 is a schematic partial enlarged diagram of the first connection structure in FIG. 1.

With combined reference to FIG. 1, FIG. 4 and FIG. 7, in some embodiments, the first connection structure 2 includes a plurality of first busbars 20 distributed at intervals along the first direction X, and the first busbars 20 extend along the first direction X; the direction of the non-cut surface 122 of the first solar cell 12 on one side of the first busbar 20 is opposite to that of the non-cut surface 122 of the first solar cell 12 on the other side of the first busbar 20. The chamfers 11 are located on the two opposite sides of the non-cut surface 122, and the direction of the non-cut surface 122 of the first solar cell 12 on one side of the first busbar 20 is opposite to that of the non-cut surface 122 of the first solar cell 12 on the other side of the first busbar 20, so that the chamfers 11 of the first solar cells 12 in the solar cell strings 1 located on the two sides of the first busbar 20 are regularly arranged, which is beneficial to improving the attractiveness of the photovoltaic module.

In some embodiments, at least two solar cell strings 1 are connected to one side of the first busbar 20, the adjacent solar cell strings 1 on one side of the first busbar 20 include the same number of first solar cells 12 and the same number of second solar cells 13, the adjacent first solar cells 12 in the adjacent solar cell strings 1 are arranged along the first direction X, and the adjacent second solar cells 13 in the adjacent solar cell strings 1 are arranged along the first direction X. The adjacent first solar cells 12 in the adjacent solar cell strings 1 are arranged along the first direction X, that is, the distances between the adjacent first solar cells 12 in the adjacent solar cell strings 1 and the solar cell 10 at the head end may be the same, that is, the positions of the adjacent first solar cells 12 in the adjacent solar cell strings 1 in the solar cell strings 1 may be the same. Similarly, the adjacent second solar cells 13 in the adjacent solar cell strings 1 are arranged along the second direction Y, and the positions of the adjacent second solar cells 13 in the adjacent solar cell strings 1 in the solar cell strings 1 are the same. With this arrangement, the first solar cells 12 in the adjacent solar cell strings 1 on one side of the first busbar 20 are regularly arranged, and the second solar cells 13 are also regularly arranged, which is beneficial to improving the attractiveness of the photovoltaic module.

Referring to FIG. 1 and FIG. 7, in some embodiments, each of the two opposite sides of the first busbar 20 electrically connects two solar cell strings 1; the second connection structure 3 includes: a second busbar 31 and a third busbar 32 spaced apart along the first direction X, the second busbar 31 extends along the first direction X and electrically connects the solar cells 10 at the tail ends of four solar cell strings 1, and the third busbar 32 extends along the first direction X and electrically connects the solar cells 10 at the tail ends of two solar cell strings 1; the second busbar 31 and the third busbar 32 located on the two sides of the first busbar 20 are arranged oppositely.

The second busbar 31 is configured to connect, in parallel, the 2 solar cell strings 1 connected with the first busbar 20. The third busbar 32 is configured to connect, in parallel, adjacent 2 solar cell strings 1 connected with the first busbar 20.

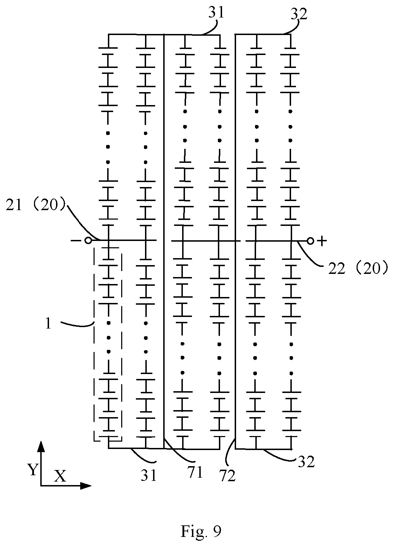

FIG. 8 is a schematic sectional structural diagram of a first jumper, an isolation film and the solar cell in the photovoltaic module according to one or more embodiments of the present disclosure; FIG. 9 is a schematic circuit diagram of the photovoltaic module according to one or more embodiments of the present disclosure.

With combined reference to FIG. 1, FIG. 4, and FIG. 7 to FIG. 9, in some embodiments, the photovoltaic module includes a first edge 15 and a second edge 16 which are opposite, the plurality of first busbars 20 include a first edge busbar 21, a second edge busbar 22 and an intermediate busbar 23, the first edge busbar 21 is adjacent to the first edge 15, the second edge busbar 22 is adjacent to the second edge 16, and the intermediate busbar 23 is located between the first edge busbar 21 and the second busbar 31. The first edge busbar 21 and the second busbar 31 electrically connect two solar cell strings 1, and in the two electrically connected solar cell strings, the non-cut surfaces 122 of the first solar cells 12 are oriented in the same direction; the intermediate busbar 23 and the second busbar 31 electrically connect two solar cell strings 1, and in the two electrically connected solar cell strings 1, the non-cut surfaces 122 of the first solar cells 2 are oriented in the same direction; the second edge busbar 22 and the third busbar 32 electrically connect two solar cell strings 1, and in the two electrically connected solar cell strings 1, the non-cut surfaces 122 of the first solar cells 12 are oriented in the same direction.

The first edge busbar 21 and the second busbar 31 connect the two solar cell strings 1 in parallel, the non-cut surfaces 122 of the first solar cells 12 in the two solar cell strings 1 connected in parallel are oriented in the same direction, and the chamfers 11 are located on the two sides of the non-cut surfaces 122, so that the chamfers 11 of the first solar cells 12 in the two solar cell strings 1 connected in parallel by the first edge busbar 21 and the second busbar 31 are regularly arranged, which is beneficial to improving the attractiveness of the photovoltaic module.

The intermediate busbar 23 and the second busbar 31 connect the two solar cell strings 1 in parallel, the non-cut surfaces 122 of the first solar cells 12 in the two solar cell strings 1 connected in parallel are oriented in the same direction, and the chamfers 11 are located on the two sides of the non-cut surfaces 122, so that the chamfers 11 of the first solar cells 12 in the two solar cell strings 1 connected in parallel by the intermediate busbar 23 and the second busbar 31 are regularly arranged, which is beneficial to improving the attractiveness of the photovoltaic module.

The second edge busbar 22 and the third busbar 32 connect the two solar cell strings 1 in parallel, the non-cut surfaces 122 of the first solar cells 12 in the two solar cell strings 1 connected in parallel are oriented in the same direction, and the chamfers 11 are located on the two sides of the non-cut surfaces 122, so that the chamfers 11 of the first solar cells 12 of the two solar cell strings 1 connected in parallel by the second edge busbar 22 and the third busbar 32 are regularly arranged, which is beneficial to improving the attractiveness of the photovoltaic module.

With combined reference to FIG. 1, FIG. 5, FIG. 8 and FIG. 9, in some embodiments, the photovoltaic module further includes a first jumper 71 and a second jumper 72, the first jumper 71 extends in the second direction Y, and the first jumper 71 electrically connects the second busbars 31 on both sides of the first busbar 20; the second jumper 72 extends in the second direction Y, and the second jumper 72 electrically connects the third busbars 32 on both sides of the first busbar 20 and is electrically connected with the intermediate busbar 23.

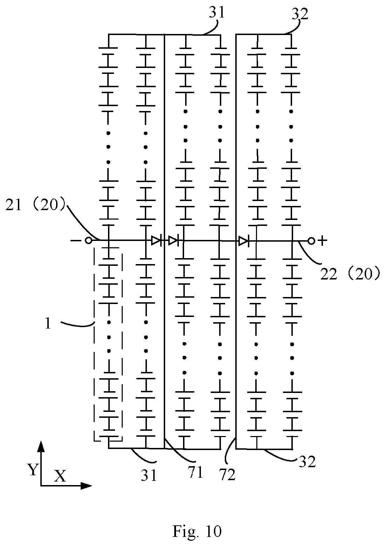

FIG. 10 is another schematic circuit diagram of the photovoltaic module according to one or more embodiments of the present disclosure.

With combined reference to FIG. 1, FIG. 5, FIG. 8 and FIG. 10, in some embodiments, the photovoltaic assembly may further include a first bypass diode (not identified), a second bypass diode (not identified), and a third bypass diode (not identified). Two ends of the first bypass diode are respectively connected with the first edge busbar 21 and the first jumper 71, and the first bypass diode can be reversely connected in parallel to the solar cell string 1 electrically connected with the first edge busbar 21, so that when the solar cell string 1 electrically connected with the first edge busbar 21 is shielded or fails, the first bypass diode can be switched on, a current bypasses the shielded or failing solar cell string 1 and flows through the first bypass diode, and power generation of other normal solar cell strings 1 of the photovoltaic module is not influenced.

Two ends of the second bypass diode are respectively connected with the intermediate busbar 23 and the first jumper 71, and the second bypass diode can be reversely connected in parallel to the solar cell string 1 electrically connected with the intermediate busbar 23, so that when the solar cell string 1 electrically connected with the intermediate busbar 23 is shielded or fails, the second bypass diode can be switched on, a current bypasses the shielded or failing solar cell string 1 and flows through the second bypass diode, and power generation of other normal solar cell strings 1 of the photovoltaic module is not influenced.

Two ends of the third bypass diode are respectively connected with the second edge busbar 22 and the first jumper 71, and the third bypass diode can be reversely connected in parallel to the solar cell string 1 electrically connected with the third edge busbar 22, so that when the solar cell string 1 electrically connected with the second edge busbar 22 is shielded or fails, the third bypass diode can be switched on, a current bypasses the shielded or failing solar cell string 1 and flows through the third bypass diode, and power generation of other normal solar cell strings 1 of the photovoltaic module is not influenced.

In some embodiments, the photovoltaic module further includes an isolation film 8, the isolation film 8 is located between the first jumper 71 and the solar cell string 1, and also located between the second jumper 72 and the solar cell string 1, and the width of the isolation film 8 in the first direction X is greater than that of the jumper 7 in the first direction X. The isolation film 8 can avoid that the first jumper 71 directly contacts the solar cell 10 in the solar cell string 1 to cause a short circuit, and can also avoid that the second jumper 72 directly contacts the solar cell 10 in the solar cell string 1 to cause a short circuit.

In some embodiments, the adhesive film 4 may be a white film, and the isolation film 8 may be a white film. Thus, the color of the isolation film may be the same as that of the adhesive film 4, thus improving the attractiveness of the photovoltaic module. In one or more examples, the adhesive film 4 may be a white EVA layer, and the isolation film 8 may be a polyethylene terephthalate (PET) layer.

The isolation film 8 may also be made of a polymer material other than PET, such as a polyvinyl butyral (PVB) layer.

With continued reference to FIG. 1 and FIG. 5, in some embodiments, the adhesive film 4 includes a first encapsulation layer covering one of a front surface and a back surface of the solar cell 10 and a second encapsulation layer covering the other of the front surface and the back surface of the solar cell 10. In some embodiments, at least one of the first encapsulation layer and the second encapsulation layer may be an organic adhesive film, such as a PVB adhesive film, an EVA adhesive film, a polyolyaltha olfin (POE) adhesive film, a PET adhesive film, or the like. Or, at least one of the first encapsulation layer and the second encapsulation layer may be an EP adhesive film, an EPE adhesive film, a PVP adhesive film, or the like. The EP adhesive film refers to a co-extrusion adhesive film formed by an EVA adhesive film and a POE adhesive film which are stacked, the EPE adhesive film refers to a co-extrusion adhesive film formed by an EVA adhesive film, a POE adhesive film and an EVA adhesive film which are stacked in sequence, and the PVP adhesive film refers to a co-extrusion adhesive film formed by a POE adhesive film, an EVA adhesive film and a POE adhesive film which are stacked. The co-extrusion adhesive film may be prepared by sequentially extruding one or more raw materials onto another prepared adhesive film or bonding different types of prepared adhesive films together during processing of the adhesive film.

In some cases, the first encapsulation layer and the second encapsulation layer have a boundary before lamination, and the concept of the first encapsulation layer and the second encapsulation layer does not exist after lamination. That is, the first encapsulation layer and the second encapsulation layer form the integral adhesive film 4.

In some embodiments, the cover plate 5 may be a glass cover plate, a plastic cover plate, or the like, having a light transmitting function. In some embodiments, a surface of the cover plate 5 facing the adhesive film 4 may be a concave-convex surface, so as to increase the utilization rate of incident light. The cover plate 5 includes a first cover plate opposite to the first encapsulation layer and a second cover plate opposite to the second encapsulation layer.

In some embodiments, the photovoltaic module is a dual-glass module, the adhesive film 4 includes a front adhesive film and a back adhesive film, the cover plate 5 includes a front cover plate and a back cover plate, the front adhesive film and the front cover plate are located on the front surface of the solar cell 10, the back adhesive film and the back cover plate are located on the back surface of the solar cell 10, the front cover plate is a glass cover plate, the front adhesive film is a high-transmittance adhesive film, the back adhesive film is a white EVA adhesive film, and the back cover plate is also a glass cover plate. The high-transmittance adhesive film can ensure that more sunlight penetrates into the module, so that the solar cell 10 can fully absorb light in short wave bands to increase a short-circuit current. The white EVA adhesive film on the back surface can lengthen a path of light inside the module through reflection, so that the solar cell can more fully absorb and utilize the light incident at various angles, thus improving the overall light utilization efficiency of the module.

In some embodiments, the photovoltaic module is a single-glass module, the adhesive film 4 includes a front adhesive film and a back adhesive film, the cover plate 5 includes a front cover plate and a back cover plate, the front adhesive film and the front cover plate are located on the front surface of the solar cell 10, the back adhesive film and the back cover plate are located on the back surface of the solar cell 10, the front cover plate is a glass cover plate, the front adhesive film is a high-transmittance adhesive film, the back adhesive film is a white EVA adhesive film, and the back cover plate is also a white back plate.

## Claims

1. A photovoltaic module, comprising:
solar cell strings, wherein each solar cell string of the solar cell strings comprises solar cells, the solar cells comprise first solar cells having chamfers and second solar cells free of chamfers, the first solar cells and the second solar cells are N segmented solar cells formed by segmenting a monolithic solar cell, N is greater than or equal to 3, and each solar cell string comprises a head end and a tail end which are oppositely disposed;
a first connection structure, wherein two opposite sides of the first connection structure are electrically connected to equal number of solar cell strings, the first connection structure is electrically connected with the solar cells located at the head ends of the solar cell strings, and the solar cells located at the tail ends of the solar cell strings on a same side of the first connection structure are exclusively the first solar cells or the second solar cells;
second connection structures located on two opposite sides of the first connection structure and electrically connected to the solar cells at the tail ends of the solar cell strings;
an adhesive film located on surfaces of the solar cell strings; and
a cover plate located on a surface of the adhesive film facing away from the solar cell strings.

2. The photovoltaic module according to claim 1, wherein the solar cells located at the tail ends of the solar cell strings on one side of the first connection structure are the first solar cells, and
the solar cells located at the tail ends of the solar cell strings on the other side of the first connection structure are the second solar cells.

3. The photovoltaic module according to claim 1, wherein one first solar cell of the first solar cells comprises a cut surface and a non-cut surface which are oppositely disposed, and the chamfers of the first solar cell are provided on two sides of the non-cut surface;
the non-cut surfaces of the first solar cells on a same solar cell string are oriented in a same direction.

4. The photovoltaic module according to claim 3, wherein the first connection structure comprises first busbars distributed at intervals along a first direction, and the first busbars extend along the first direction;
an orientation of the non-cut surface of the first solar cell on one side of the first busbar is opposite to an orientation of the non-cut surface of the first solar cell on the other side of the first busbar.

5. The photovoltaic module according to claim 4, wherein at least two solar cell strings are connected to one side of one first busbar of the first busbars, adjacent solar cell strings on one side of the first busbar comprise a same number of first solar cells and a same number of second solar cells, and
adjacent first solar cells in the adjacent solar cell strings are arranged along the first direction, and adjacent second solar cells in the adjacent solar cell strings are arranged along the first direction.

6. The photovoltaic module according to claim 5, wherein each of the two opposite sides of the first busbar are electrically connected to two solar cell strings;
the second connection structure comprises: a second busbar and a third busbar that are spaced apart along the first direction,
the second busbar extends along the first direction and is electrically connected to the solar cells at the tail ends of four solar cell strings, and
the third busbar extends along the first direction and is electrically connected to the solar cells at the tail ends of two solar cell strings.

7. The photovoltaic module according to claim 6, comprising a first edge and a second edge which are oppositely disposed,
wherein the first busbars comprise a first edge busbar, a second edge busbar and an intermediate busbar, the first edge busbar is adjacent to the first edge, the second edge busbar is adjacent to the second edge, and the intermediate busbar is located between the first edge busbar and the second busbar;
the first edge busbar and the second busbar are electrically connected to two solar cell strings, and in the two solar cell strings, non-cut surfaces of the first solar cells are oriented in a same direction.

8. The photovoltaic module according to claim 7, wherein
the intermediate busbar and the second busbar are electrically connected to two solar cell strings, and in the two solar cell strings, non-cut surfaces of the first solar cells are oriented in a same direction;
the second edge busbar and the third busbar are electrically connected to two solar cell strings, and in the two solar cell strings, non-cut surfaces of the first solar cells are oriented in a same direction.

9. The photovoltaic module according to claim 8, further comprising:
a first jumper extending in a second direction and electrically connected to second busbars on both sides of the first busbar; and
a second jumper extending in the second direction, and electrically connected to third busbars on both sides of the first busbar and also electrically connected to the intermediate busbar.

10. The photovoltaic module according to claim 1, wherein adjacent solar cells in the solar cell string are partially overlapped, a length of a partially overlapped region of the adjacent solar cells along a second direction is defined as a first length ranging from 0 mm to 0.4mm.

11. The photovoltaic module according to claim 10, wherein the first length ranges from 0.1 mm to 0.3 mm.

12. The photovoltaic module according to claim 10, a size of the chamfer of the first solar cell is smaller than or equal to the first length.

13. The photovoltaic module according to claim 1, wherein adjacent solar cells in the solar cell string are arranged at intervals, and a distance between the adjacent solar cells along the second direction ranges from 0 mm to 1.5 mm.

14. The photovoltaic module according to claim 1, wherein a width of the photovoltaic module along a first direction X ranges from 1,130 mm to 1,140 mm; and
a length of the photovoltaic module along a second direction ranges from 1,854 mm to 1,906 mm.

15. The photovoltaic module according to claim 1, comprising first solar cells and second solar cells which are formed by cutting 51 monolithic solar cells.
